# EUROPEAN PATENT APPLICATION

(11) **EP 4 484 607 A1**
(43) Date of publication of application: **01.01.2025**
(21) Application number: 24165560.4
(22) Date of filing: 22.03.2024
(51) Int. Cl.: C23C 16/30, C23C 16/40, C23C 16/44, C23C 16/452, C23C 16/455, H01L 21/67, H01L 21/02

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 28.06.2023 JP 2023105763
(71) Applicant: Kokusai Electric Corp., Tokyo 1010045 (JP)
(72) Inventor: HANASHIMA, Takeo, Toyama-shi, Toyama, 9392393 (JP); NAKASHIMA, Satoshi, Toyama-shi, Toyama, 9392393 (JP)
(74) Representative: Bardehle Pagenberg Partnerschaft mbB Patentanwälte Rechtsanwälte

(57) **Abstract**

There is provided a technique that includes (a) performing a first process to a substrate accommodated in a process container by supplying a first processing gas into the process container through a first pipe different from a second pipe, which is connected to the process container and includes an inner surface made of a metal-containing material, in a state in which the second pipe is heated to a first temperature or higher and (b) performing a second process to the substrate by supplying a second processing gas containing oxygen into the process container through the second pipe in a state in which a temperature of the second pipe is lowered to a second temperature lower than the first temperature.

## Description

### CROSS-REFERENCE TO RELATED APPLICATION

This application is based upon and claims the benefit of priority from Japanese Patent Application No. 2023-105763, filed on June 28, 2023, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

As a process of manufacturing a semiconductor device, a process is sometimes performed to form a film on a substrate.

### SUMMARY

Some embodiments of the present disclosure provide a technique capable of, when supplying an oxygen-containing gas through a pipe whose inner surface is made of a metal-containing material, suppressing an increase in pipe temperature due to the reaction between the inner surface and the gas.

According to one embodiment of the present disclosure, there is provided a technique that includes (a) performing a first process to a substrate accommodated in a process container by supplying a first processing gas into the process container through a first pipe different from a second pipe, which is connected to the process container and includes an inner surface made of a metal-containing material, in a state in which the second pipe is heated to a first temperature or higher and (b) performing a second process to the substrate by supplying a second processing gas containing oxygen into the process container through the second pipe in a state in which a temperature of the second pipe is lowered to a second temperature lower than the first temperature.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in one embodiment of the present disclosure, in which a portion of a process furnace is illustrated in a vertical sectional view.
FIG. 2 is a schematic configuration diagram of the vertical process furnace of the substrate processing apparatus suitably used in one embodiment of the present disclosure, in which the portion of the process furnace is illustrated in a sectional view taken along line A-A in FIG. 1.
FIG. 3 is a schematic configuration diagram of a controller of the substrate processing apparatus suitably used in one embodiment of the present disclosure, in which a control system of the controller is illustrated in a block diagram.
FIG. 4 is a diagram showing a processing sequence in one embodiment of the present disclosure.
FIG. 5 is a flowchart showing a flow of a substrate processing process in one embodiment of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

### <One Embodiment of the Present Disclosure>

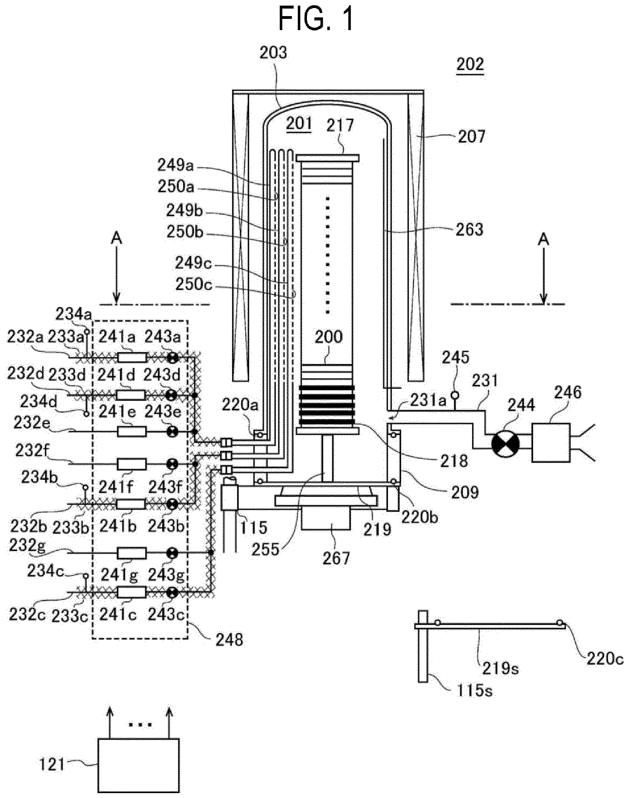

Hereinafter, one embodiment of the present disclosure will be described mainly with reference to FIGS. 1 to 5. Further, the drawings used in the following description are all schematic, and a dimensional relationship of each element, a ratio of each element, and the like shown in the drawings do not necessarily match the actual ones. Furthermore, the dimensional relationship of each element, the ratio of each element, and the like do not necessarily match among a plurality of the drawings.

### (1) Configuration of Substrate Processing Apparatus

As shown in FIG. 1, a process furnace 202 includes a heater 207 as a temperature adjustment part (heating part). The heater 207 has a cylindrical shape and is vertically installed by being supported by a holding plate. The heater 207 also functions as an activation mechanism (excitation part) that activates (excites) a gas with heat.

Inside the heater 207, a reaction tube 203 is arranged concentrically with the heater 207. The reaction tube 203 is made of a heat-resistant material such as quartz (SiO₂) or silicon carbide (SiC), and has a cylindrical shape with a closed upper end and an open lower end. A manifold 209 is arranged below the reaction tube 203 and concentrically with the reaction tube 203. The manifold 209 is made of a metal-containing material such as stainless steel (SUS), and has a cylindrical shape with open upper and lower ends. The upper end of the manifold 209 is engaged with the lower end of the reaction tube 203 and is configured to support the reaction tube 203. An O-ring 220a is installed between the manifold 209 and the reaction tube 203 as a sealing member. As with the heater 207, the reaction tube 203 is installed vertically. A process container (reaction container) mainly includes the reaction tube 203 and the manifold 209. A process chamber 201 is formed in a cylindrical hollow portion of the process container. The process chamber 201 is configured to be capable of accommodating wafers 200 as substrates. Processing to the wafer 200 is performed inside the process chamber 201.

Inside the process chamber 201, each of nozzles 249a to 249c as first to third supply parts is installed to penetrate a side wall of the manifold 209. The nozzles 249a to 249c are also referred to as first to third nozzles, respectively. The nozzles 249a to 249c are made of a heat-resistant material such as quartz or SiC. Gas supply pipes 232a to 232c are connected to the nozzles 249a to 249c, respectively. The nozzles 249a to 249c are different nozzles, and each of the nozzles 249b and 249c is installed adjacent to the nozzle 249a.

The gas supply pipes 232a to 232c are connected to the nozzles 249a to 249c, respectively. Each of the gas supply pipes 232a to 232c is configured as a shared pipe used to supply multiple types of gases. In the gas supply pipes 232a to 232c, mass flow controllers (MFC) 241a to 241c, which are flow rate controllers (flow rate control parts), and valves 243a to 243c, which are opening/closing valves, are installed sequentially from upstream sides of gas flows, respectively. Each of gas supply pipes 232d and 232e is connected to a downstream side of the valve 243a of the gas supply pipe 232a. In the gas supply pipes 232d and 232e, MFCs 241d and 241e and valves 243d and 243e are installed sequentially from upstream sides of gas flows, respectively. A gas supply pipe 232f is connected to a downstream side of the valve 243b of the gas supply pipe 232b. In the gas supply pipe 232f, an MFC 241f and a valve 243f are installed sequentially from an upstream side of a gas flow. A gas supply pipe 232g is connected to a downstream side of the valve 243c of the gas supply pipe 232c. In the gas supply pipe 232g, an MFC 241g and a valve 243g are installed sequentially from an upstream side of a gas flow. The gas supply pipes 232a to 232g are made of a metal-containing material such as SUS and the inner surfaces thereof are also made of a metal-containing material such as SUS. In this specification, each or all of the gas supply pipes 232a, 232b, and 232d may be referred to as a first pipe, and the gas supply pipe 232c may be referred to as a second pipe.

Pipe temperature sensors 234a, 234b, and 234d, which are temperature detectors, are installed in upstream sides of the MFCs 241a, 241b, and 241d of the gas supply pipes 232a, 232b, and 232d as the first pipes, respectively. A pipe temperature sensor 234c is installed in an upstream side of the MFC 241c of the gas supply pipe 232c as the second pipe. The pipe temperature sensor may be configured by a known temperature sensor such as a thermocouple. Furthermore, in the present embodiment, pipe heaters 233a, 233b, and 233d as heating parts are installed on outer peripheries of the gas supply pipes 232a, 232b, and 232d as the first pipes, respectively. A pipe heater 233b is installed on an outer periphery of the gas supply pipe 232c as a second pipe.

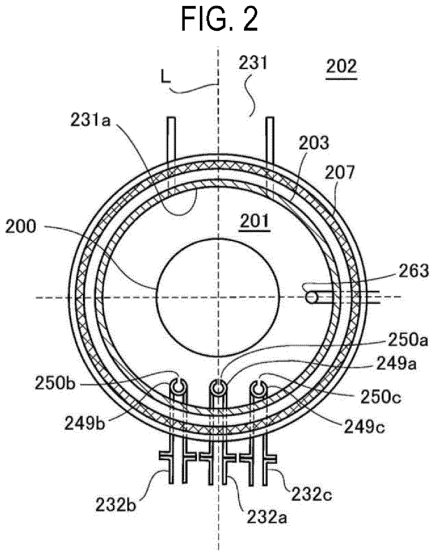

As shown in FIG. 2, the nozzles 249a to 249c are arranged in a space having an annular shape in a plane view between an inner wall of the reaction tube 203 and the wafers 200 and are installed to extend upward in an arrangement direction of the wafers 200 from a lower portion to an upper portion of the inner wall of the reaction tube 203. In other words, the nozzles 249a to 249c are respectively installed in a region horizontally surrounding a wafer arrangement region, in which the wafers 200 are arranged, on a lateral side of the wafer arrangement region to extend along the wafer arrangement region. In a plane view, the nozzle 249a is arranged to face an exhaust port 231a described later in a straight line that passes through centers of the wafers 200 loaded into the process chamber 201. The nozzles 249b and 249c are arranged to sandwich a straight line L passing through centers of the nozzle 249a and the exhaust port 231a from both sides along the inner wall of the reaction tube 203 (outer peripheral portions of the wafers 200). The straight line L is also a straight line passing through the centers of nozzle 249a and the wafers 200. That is, it can be said that the nozzle 249c is installed on a side opposite to the nozzle 249b with the straight line L interposed therebetween. The nozzles 249b and 249c are arranged line-symmetrically with the straight line L as an axis of symmetry. Gas supply holes 250a to 250c for supplying gases are formed on side surfaces of the nozzles 249a to 249c, respectively. Each of the gas supply holes 250a to 250c are opened to face the exhaust port 231a in a plane view and can supply a gas toward the wafers 200. The gas supply holes 250a to 250c are formed from a lower portion to an upper portion of the reaction tube 203.

A precursor gas as a first processing gas is supplied from the gas supply pipe 232a into the process chamber 201 through the MFC 241a, the valve 243a, and the nozzle 249a.

A second reaction gas as a first processing gas is supplied from the gas supply pipe 232b into the process chamber 201 through the MFC 241b, the valve 243b, and the nozzle 249b.

A second processing gas containing oxygen (O) is supplied from the gas supply pipe 232c into the process chamber 201 through the MFC 241c, the valve 243c, and the nozzle 249c.

A first reaction gas as a first processing gas is supplied from the gas supply pipe 232d into the process chamber 201 through the MFC 241d, the valve 243d, and the nozzle 249a.

An inert gas is supplied from the gas supply pipes 232e to 232g into the process chamber 201 through the MFCs 241e to 241g, the valves 243e to 243g, the gas supply pipes 232a to 232c, and the nozzles 249a to 249c, respectively. The inert gas acts as a purge gas, a carrier gas, a dilution gas, or the like.

A precursor gas supply system mainly includes the gas supply pipe 232a, the MFC 241a, and the valve 243a. A second reaction gas supply system mainly includes the gas supply pipe 232b, the MFC 241b, and the valve 243b. A second processing gas supply system mainly includes the gas supply pipe 232c, the MFC 241c, and the valve 243c. A first reaction gas supply system mainly includes the gas supply pipe 232d, the MFC 241d, and the valve 243d. An inert gas supply system mainly includes the gas supply pipes 232e to 232g, the MFCs 241e to 241g, and the valves 243e to 243g. In the present embodiment, the precursor gas supply system, the first reaction gas supply system, and the second reaction gas supply system are collectively referred to as a first processing gas supply system. The nozzles connected to the gas supply pipes constituting the various supply systems described above may be included in each of the supply systems.

Any or all of the various supply systems described above may be configured as an integrated supply system 248 in which the valves 243a to 243g, the MFCs 241a to 241g, and the like are integrated. The integrated supply system 248 is connected to each of the gas supply pipes 232a to 232g, and is configured so that operations of supplying various substances (various gases) into the gas supply pipes 232a to 232g, i.e., opening/closing operations of the valves 243a to 243g, flow rate adjustment operations by the MFCs 241a to 241g, and the like are controlled by a controller 121, which will be described later. The integrated supply system 248 is configured as an integral or a divided integrated unit, so that attachment and detachment with respect to the gas supply pipes 232a to 232g and the like can be performed on an integrated unit basis and maintenance, replacement, expansion, and the like of the integrated supply system 248 can be performed on the integrated unit basis.

The exhaust port 231a is installed below a side wall of the reaction tube 203 to exhaust an atmosphere inside the process chamber 201. As shown in FIG. 2, the exhaust port 231a is installed at a position opposite to (facing) the nozzles 249a to 249c (the gas supply holes 250a to 250c), such that the wafers 200 are between the exhaust port 231a and the nozzles 249a to 249c, in a plane view. The exhaust port 231a may be installed to extend from a lower portion to an upper portion of the side wall of the reaction tube 203, i.e., along the wafer arrangement region. An exhaust pipe 231 is connected to the exhaust port 231a. The exhaust pipe 231 is made of a metal-containing material such as SUS. A vacuum pump 246 as a vacuum evacuator is connected to the exhaust pipe 231 via a pressure sensor 245 as a pressure detector (pressure detection part) that detects a pressure inside the process chamber 201 and an APC (Auto Pressure Controller) valve 244 as a pressure regulator (pressure regulation part). The APC valve 244 can start and stop evacuation of an inside of the process chamber 201 by being opened and closed while the vacuum pump 246 is in operation. Further, the APC valve 244 can regulate the pressure inside the process chamber 201 by adjusting a valve opening degree based on pressure information detected by the pressure sensor 245 while the vacuum pump 246 is in operation. An exhaust system mainly includes the exhaust pipe 231, the APC valve 244, and the pressure sensor 245. The vacuum pump 246 may be included in the exhaust system.

A seal cap 219 is installed below the manifold 209 as a furnace opening lid that can airtightly close a lower end opening of the manifold 209. The seal cap 219 is made of a metal-containing material such as SUS and is formed in a disk shape. An O-ring 220b as a sealing member that comes into contact with a lower end of the manifold 209 is installed on an upper surface of the seal cap 219. A rotation mechanism 267 for rotating a boat 217, which will be described later is installed below the seal cap 219. A rotary shaft 255 of the rotation mechanism 267 is made of a metal-containing material such as SUS and is connected to the boat 217 through the seal cap 219. The rotation mechanism 267 is configured to rotate the wafers 200 by rotating the boat 217. The seal cap 219 is configured to be raised and lowered in a vertical direction by a boat elevator 115 as an elevating installed outside the reaction tube 203. The boat elevator 115 is configured as a transfer (transfer mechanism) that loads and unloads (transfers) the wafers 200 into and out of the process chamber 201 by raising and lowering the seal cap 219.

A shutter 219s as a furnace opening lid that can airtightly close the lower end opening of the manifold 209, in a state in which the seal cap 219 is lowered and the boat 217 is taken out of the process chamber 201, is installed below the manifold 209. The shutter 219s is made of a metal-containing material such as SUS and is formed in a disk shape. An O-ring 220c as a sealing member that comes into contact with the lower end of the manifold 209 is installed on an upper surface of the shutter 219s. Opening and closing operations (elevating and lowering operations, rotating operations, etc.) of the shutter 219s are controlled by a shutter opening/closing mechanism 115s.

The boat 217 as a substrate holder is configured to support a plurality of wafers 200, for example, 25 to 200 wafers 200, in a horizontal posture to be aligned in the vertical direction in multiple stages, i.e., arranged in a spaced-apart relationship, with their centers aligned with each other. The boat 217 is made of a heat-resistant material such as quartz or SiC. Under the boat 217, heat insulating plates 218 made of a heat-resistant material such as quartz or SiC are supported in multiple stages.

A temperature sensor 263 as a temperature detector is installed inside the reaction tube 203. By adjusting a power supply to the heater 207 based on the temperature information detected by the temperature sensor 263, a temperature in the process chamber 201 is set to be a desired temperature distribution. The temperature sensor 263 is installed along the inner wall of the reaction tube 203.

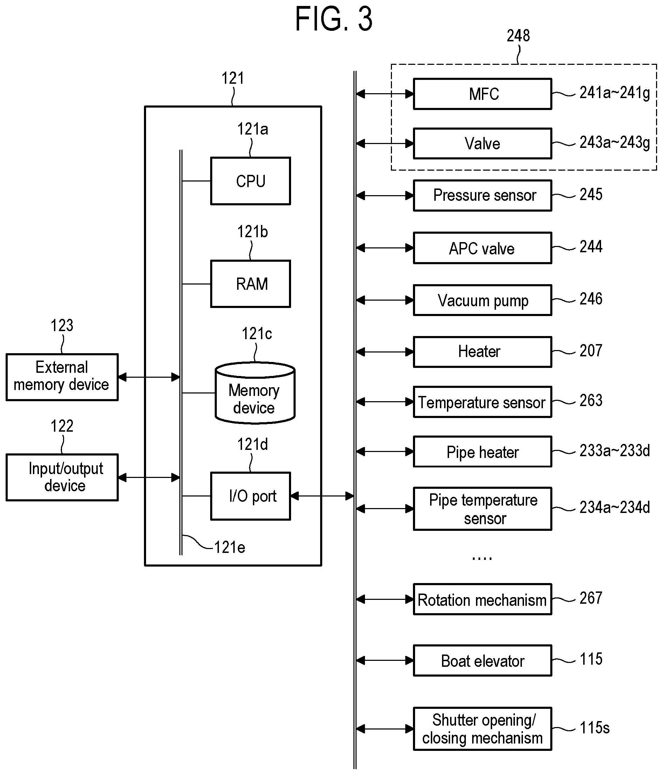

As shown in FIG. 3, the controller 121, which is a control part (control means), is configured as a computer that includes a CPU (Central Processing Unit) 121a, a RAM (Random Access Memory) 121b, a memory device 121c, and an I/O port 121d. The RAM 121b, the memory device 121c, and the I/O port 121d are configured to be able to exchange data with the CPU 121a via an internal bus 121e. An input/output device 122 configured as, for example, a touch panel is connected to the controller 121. Further, an external memory device 123 can be connected to the controller 121.

The memory device 121c includes, for example, a flash memory, an HDD (Hard Disk Drive), or an SSD (Solid State Drive). In the memory device 121c, there are readably recorded and stored a control program for controlling operation of the substrate processing apparatus, a process recipe in which procedures and conditions of substrate processing to be described later are written, and the like. The process recipe is a combination that causes the controller 121 to have the substrate processing apparatus execute the respective procedures in a below-described substrate processing to obtain a predetermined result. The process recipe functions as a program. Hereinafter, the process recipe, the control program and the like are collectively and simply referred to as a program. Furthermore, the process recipe is also simply referred to as a recipe. When the term "program" is used herein, it may mean a case of including only the recipe, a case of including only the control program, or a case of including both the recipe and the control program. The RAM 121b is configured as a memory area (work area) in which programs, data, and the like read by the CPU 121a are temporarily held.

The I/O port 121d is connected to the MFCs 241a to 241g, the valves 243a to 243g, the pressure sensor 245, the APC valve 244, the vacuum pump 246, the temperature sensor 263, the pipe temperature sensors 234a to 234d, the heater 207, the pipe heater 233a to 233d, the rotation mechanism 267, the boat elevator 115, the shutter opening/closing mechanism 115s, and the like.

The CPU 121a is configured to be capable of reading a control program from the memory device121c and executing the control program and is configured to be capable of reading a recipe from the memory device 121c in response to an input of operation commands from the input/output device 122. The CPU 121a is configured to be capable of controlling, according to a content of the recipe thus read, flow rate adjustment operation for various substances (various gases) by the MFCs 241a to 241g, opening and closing operations of the valves 243a to 243g, opening and closing operations of the APC valve 244, pressure adjustment operation by the APC valve 244 based on the pressure sensor 245, startup and stop of the vacuum pump 246, temperature adjustment operation of the heater 207 based on the temperature sensor 263, rotation and rotational speed adjustment operation for the boat 217 by the rotation mechanism 267, raising and lowering operations of the boat 217 by the boat elevator 115, opening and closing operations of the shutter 219s by the shutter opening/closing mechanism 115s.

The controller 121 can be configured by installing the above-mentioned program recorded and stored in the external memory device 123 into a computer. The external memory device 123 includes, for example, a magnetic disk such as an HDD, an optical disk such as a CD, a magneto-optical disk such as an MO, a semiconductor memory such as a USB memory or an SSD. The memory device 121c and the external memory device 123 are configured as computer-readable recording media. Hereinafter, these will be collectively referred to as a recording medium. When the term "recording medium" is used in this specification, it may include only the memory device 121c, only the external memory device 123, or both. The program may be provided to the computer using communication means such as an Internet or a dedicated line, without using the external memory device 123.

### (2) Substrate Processing Process

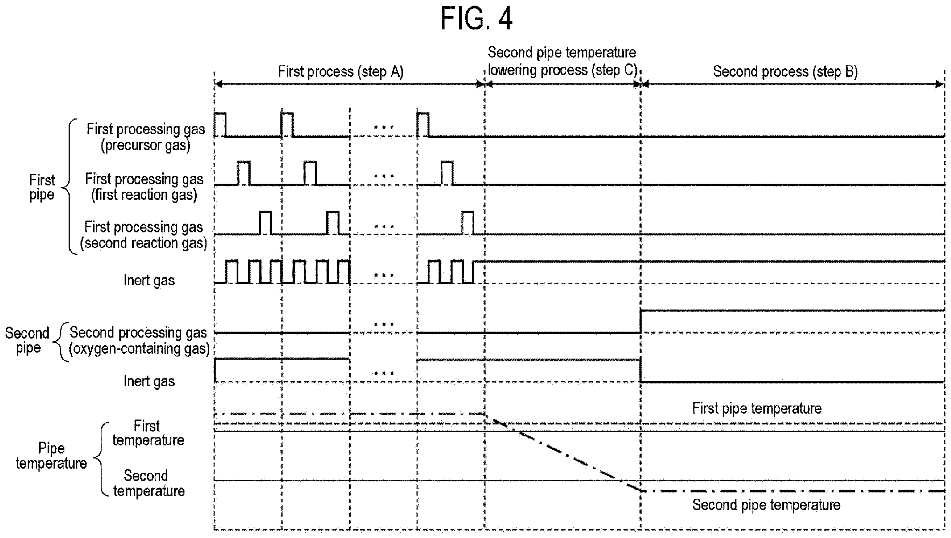

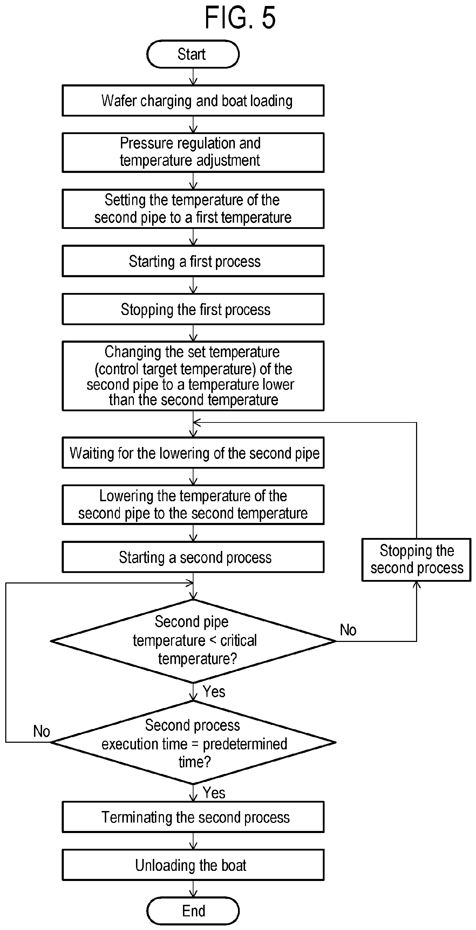

A method of processing a substrate as one of processes of manufacturing a semiconductor device using the above-described substrate processing apparatus, i.e., an example of a series of processing sequences including a film formation sequence for forming a film on the wafer 200 as a substrate, will be described mainly with reference to FIGS. 4 and 5. In the following description, operation of each part constituting the substrate processing apparatus is controlled by the controller 121.

The processing sequence according to the present embodiment includes:
(a) step A of performing a first process to the wafer 200 accommodated in the process container by supplying a first processing gas into the process container through the first pipes (gas supply pipes 232a, 232b and 232d) different from a second pipe (gas supply pipe 232c), which is connected to the process container and includes an inner surface made of a metal-containing material, in a state in which the second pipe is heated to a first temperature or higher; and
(b) step B of performing a second process to the wafer 200 by supplying a second processing gas containing oxygen into the process container through the second pipe in a state in which a temperature of the second pipe is lowered to a second temperature lower than the first temperature.

In the processing sequence according to the present embodiment, there is shown an example in which in step A, a film is formed on the wafer 200 by performing a cycle including step a1 of supplying a precursor gas as the first processing gas to the wafer 200, step a2 of supplying a first reaction gas as the first processing gas to the wafer 200, and step a3 of supplying a second reaction gas as the first processing gas to the wafer 200, a predetermined number of times (n times where n is an integer of 1 or 2 or more). In this specification, each or all of the precursor gas, the first reaction gas, and the second reaction gas may be referred to as a first processing gas.

In the processing sequence according to the present embodiment, there is shown an example in which in step B, the film formed on the wafer 200 is treated by supplying the second processing gas containing oxygen (O) to the wafer 200.

Further, in the processing sequence according to the present embodiment, there is shown an example in which the processing sequence further includes: step C of lowering the temperature of the second pipe from a temperature equal to or higher than the first temperature to the second temperature lower than the first temperature in a period between step A and step B.

Furthermore, an example in which a silicon oxynitride film (SiON film) is formed as a film on the wafer 200 will be described below.

In this specification, the processing sequence described above may also be denoted as follows for the sake of convenience. The same notation is also used in the following description of modifications and other embodiments. (precursor gas —> first reaction gas —> second reaction gas) × n —> second pipe temperature decrease —> second processing gas containing O

The term "wafer" used herein may refer to a wafer itself or a stacked body of a wafer and a predetermined layer or film formed on the surface of the wafer. The phrase "a surface of a wafer" used herein may refer to a surface of a wafer itself or a surface of a predetermined layer or the like formed on a wafer. The expression "a predetermined layer is formed on a wafer" used herein may mean that a predetermined layer is directly formed on a surface of a wafer itself or that a predetermined layer is formed on a layer or the like formed on a wafer. The term "substrate" used herein may be synonymous with the term "wafer."

As used herein, the term "layer" includes at least one of a continuous layer and a discontinuous layer. For example, a Si-containing layer, which will be described later, may include a continuous layer, a discontinuous layer, or both of them.

In this specification, the description that the first processing gas and the second processing gas containing O are adsorbed onto or reacted with the surface of the wafer 200 may include not only a case where the gases are adsorbed onto or reacted with the surface of the wafer 200 without being decomposed, but also a case where intermediates generated by decomposition of the gases and desorption of ligands are adsorbed onto or reacted with the surface of the wafer 200.

### (Wafer Charging and Boat Loading)

When a plurality of wafers 200 are charged onto the boat 217 (wafer charging), the shutter 219s is moved by the shutter opening/closing mechanism 115s, and the lower end opening of the manifold 209 is opened (shutter opening). Thereafter, as shown in FIG. 1, the boat 217 supporting the plurality of wafers 200 is lifted by the boat elevator 115 and loaded into the process chamber 201 (boat loading). In this state, the seal cap 219 seals the lower end of the manifold 209 via the O-ring 220b. In this way, the wafers 200 are prepared (provided) within the process chamber 201.

### (Pressure Regulation and Temperature Adjustment)

After the boat loading is completed, the inside of the process chamber 201, i.e., a space where the wafers 200 exist, is evacuated (depressurized) by the vacuum pump 246 so that a desired pressure (degree of vacuum) is achieved. At this time, the pressure inside the process chamber 201 is measured by the pressure sensor 245 and the APC valve 244 is feedback-controlled based on the measured pressure information. Further, the wafers 200 in the process chamber 201 are heated by the heater 207 so that the temperature thereof reaches a desired processing temperature. At this time, the power supply to the heater 207 is feedback-controlled based on the temperature information detected by the temperature sensor 263 so that the inside of the process chamber 201 is set to be a desired temperature distribution. Further, the rotation of the wafers 200 by the rotation mechanism 267 is started. The evacuation of the process chamber 201, the heating of the wafers 200, and the rotation of the wafers 200 are all continued at least until the processing of the wafers 200 is completed.

### (Second Pipe Temperature Setting)

Thereafter, the pipe heater 233c heats the second pipe (gas supply pipe 232c) so that the temperature inside the second pipe becomes a first temperature or higher. At this time, the power supply to the pipe heater 233c is feedback-controlled based on the temperature information detected by the pipe temperature sensor 234c so that the inside of the second pipe is set to be a desired temperature distribution. At this time, it is preferable that the temperature inside the first pipes (gas supply pipes 232a, 232b and 232d) is also heated by the pipe heaters 233a, 233b, and 233d, respectively, so that the temperature inside the first pipes becomes equal to or higher than the first temperature. Furthermore, the timing at which the process of heating the second pipe to the first temperature is performed is not limited to after the pressure regulation and temperature adjustment. The timing may be the same timing as or before the wafer charging and boat loading or the pressure regulation and temperature adjustment.

### (First Process: Step A)

Thereafter, the following steps a1, a2 and a3 are performed sequentially.

### [Step a1]

In this step, the precursor gas is supplied to the wafers 200 in the process chamber 201.

Specifically, the valve 243a is opened to allow the precursor gas to flow into the gas supply pipe 232a (first pipe). The flow rate of the precursor gas is adjusted by the MFC 241a. The precursor gas is supplied into the process chamber 201 through the nozzle 249a and is exhausted from the exhaust port 231a. At this time, the precursor gas is supplied to the wafer 200 (precursor gas supply). At this time, the valves 243e to 243g may be opened to supply the inert gas into the process chamber 201 through the nozzles 249a to 249c, respectively. The inert gas supplied through the nozzles 249b and 249c also acts as an intrusion suppressing gas that suppresses the precursor and the like in the process chamber from intruding (backflowing) into the nozzles 249a and 249b.

Processing conditions when supplying the precursor in this step are exemplified as follows.
Processing temperature: 350 to 900 degrees C, preferably 500 to 900 degrees C, more preferably 600 to 800 degrees C
Processing pressure: 1 to 10,000 Pa, preferably 10 to 1,333 Pa
First pipe temperature: equal to or higher than the first temperature, for example, 160 to 250 degrees C, preferably 180 to 250 degrees C
Second pipe temperature: equal to or higher than the first temperature, for example, 160 to 250 degrees C, preferably 180 to 250 degrees C
Precursor gas supply flow rate: 0.01 to 3 slm, preferably 0.1 to 1 slm
Precursor gas supply time: 10 to 120 seconds, preferably 20 to 60 seconds
Inert gas supply flow rate (for each gas supply pipe): 0 to 10 slm

In this specification, the notation of a numerical range such as "350 to 900 degrees C" means that the lower limit and upper limit are included in the range. Therefore, for example, "350 to 900 degrees C" means "350 degrees C or higher and 900 degrees C or lower." The same applies to other numerical ranges. Further, the processing temperature in this specification means the temperature of the wafer 200 or the temperature inside the process chamber 201, and the processing pressure means the pressure inside the process chamber 201, i.e., the pressure in the space in which the wafers 200 exist. Further, the processing time means the time during which the process is continued. Moreover, the pipe temperature means the temperature inside the pipe. Furthermore, when the supply flow rate includes 0 slm, the 0 slm means a case in which the substance (gas) is not supplied. The same applies to the following description.

By supplying, for example, a chlorosilane-based gas as the precursor gas to the wafer 200 under the above conditions, a silicon (Si)-containing layer containing chlorine (Cl) is formed on the outermost surface of the wafer 200 as a base. The Si-containing layer containing Cl is formed by physical adsorption or chemical adsorption of molecules of the chlorosilane-based gas onto the outermost surface of the wafer 200, physical adsorption or chemical adsorption of molecules of a substance generated by partial decomposition of the chlorosilane-based gas, deposition of Si due to thermal decomposition of the chlorosilane-based gas, and the like. The Si-containing layer containing Cl may be an adsorption layer (physical adsorption layer or chemical adsorption layer) of molecules of the chlorosilane-based gas or molecules of a substance generated by partial decomposition of the chlorosilane-based gas or may be a deposition layer of Si containing Cl. In this specification, the Si-containing layer containing Cl is also simply referred to as a Si-containing layer.

As the precursor gas, for example, a silane-based gas containing Si as a main element constituting the film formed on the wafer 200 may be used. As the silane-based gas, for example, a gas containing Si and a halogen, i.e., a halosilane-based gas may be used. Halogen includes chlorine (Cl), fluorine (F), bromine (Br), iodine (I), and the like. As the halosilane-based gas, for example, the above-mentioned chlorosilane-based gas containing Si and Cl may be used.

As the precursor gas, for example, a chlorosilane-based gas such as a monochlorosilane (SiH₃Cl) gas, a dichlorosilane (SiH₂Cl₂) gas, a trichlorosilane (SiHCl₃) gas, a tetrachlorosilane (SiCl₄) gas, a hexachlorodisilane gas (Si₂Cl₆) gas, an octachlorotrisilane (Si₃Cl₈) gas may be used. As the precursor gas, one or more of these gases may be used.

As the precursor gas, in addition to the chlorosilane-based gas, it may be possible to use, for example, a fluorosilane-based gas such as a tetrafluorosilane (SiF₄) gas, a difluorosilane (SiH₂F₂) gas or the like, a bromosilane-based gas such as a tetrabromosilane (SiBr4) gas, a dibromosilane (SiH₂Br₂) gas or the like, and an iodosilane-based gas such as a tetraiodosilane (SiI₄) gas, a diiodosilane (SiH₂I₂) gas or the like. As the precursor gas, one or more of these gases may be used.

As the precursor gas, in addition to these gases, it may also be possible to use, for example, a gas containing Si and an amino group, i.e., an aminosilane-based gas. The amino group is a monovalent functional group obtained by removing hydrogen (H) from ammonia, primary amine, or secondary amine, and may be expressed as -NH₂, -NHR, or -NR₂. R represents an alkyl group, and the two R's in -NR₂ may be the same or different.

As the precursor gas, it may also be possible to use, for example, an aminosilane-based gas such as a tetrakis(dimethylamino)silane (Si[N(CH₃)₂]₄) gas, a tris(dimethylamino)silane (Si[N(CH₃)₂]₃H) gas, a bis(diethylamino)silane (Si[N(C₂H₅)₂]₂H₂) gas, a bis(tert-butylamino)silane (SiH₂[NH(C₄H₉)]₂) gas, or a (diisopropylamino)silane (SiH₃[N(C₃H₇)₂]) gas. As the precursor gas, one or more of these gases may be used.

As the inert gas, for example, a nitrogen (N₂) gas or a rare gas such as an argon (Ar) gas, a helium (He) gas, a neon (Ne) gas, or a xenon (Xe) gas may be used. One or more of these gases may be used as the inert gas. This point also applies to each step described below.

After the Si-containing layer is formed, the valve 243a is closed to stop the supply of the precursor gas into the process chamber 201. Then, the inside of the process chamber 201 is evacuated, and the gas remaining in the process chamber 201 is removed from the inside of the process chamber 201 (purging). At this time, the valves 243e to 243g are opened to supply the inert gas into the process chamber 201. The inert gas acts as a purge gas.

### [Step a2]

After step a1 is completed, the first reaction gas is supplied to the wafer 200 in the process chamber 201, i.e., to the Si-containing layer formed on the wafer 200.

Specifically, the valve 243d is opened to allow the first reaction gas to flow into the gas supply pipe 232d (first pipe). The flow rate of the first reaction gas is adjusted by the MFC 241d. The first reaction gas is supplied into the process chamber 201 through the nozzle 249a and is exhausted from the exhaust port 231a. At this time, the first reaction gas is supplied to the wafer 200 (first reaction gas supply). At this time, the valves 243e to 243g may be opened to supply the inert gas into the process chamber 201 through the nozzles 249a to 249c, respectively.

The processing conditions when supplying the first reaction gas in this step is exemplified as follows.
first reaction gas supply flow rate: 0.01 to 4 slm, preferably 0.3 to 1 slm
first reaction gas supply time: 1 to 60 seconds, preferably 5 to 20 seconds
Other processing conditions may be the same as those in step a1.

By supplying, for example, an O-containing gas as the first reaction gas to the wafer 200 under the above conditions, at least a portion of the Si-containing layer formed on the wafer 200 is oxidized (modified). As a result, a silicon oxide layer (SiO layer) as a layer containing Si and O is formed on the outermost surface of the wafer 200 as a base. In the present embodiment, for example, an O-containing gas is used as the first reaction gas. Hereinafter, the first reaction gas may be referred to as a first O-containing gas.

The reactivity of the first O-containing gas used in this step with the metal-containing material constituting the inner surface of the gas supply pipe 232d (first pipe) is smaller than the reactivity of a second O-containing processing gas used in step B, which will be described later, with the metal-containing material constituting the inner surface of the gas supply pipe 232c (second pipe). The reactivity referred to herein mainly includes ease of occurrence of an oxidation reaction (oxidizing power). As a result, even if the inner surface of the gas supply pipe 232d is made of a metal-containing material, it is possible to suppress an increase in the temperature of the gas supply pipe 232d due to the reaction between the first O-containing gas and the metal-containing material in this step.

As the first reaction gas, for example, an oxygen (O₂) gas, a nitrous oxide (N₂O) gas, a nitrogen monoxide (NO) gas, a nitrogen dioxide (NO₂) gas, a carbon monoxide (CO) gas, or a carbon dioxide (CO₂) gas may be used. One or more of these gases may be used as the first reaction gas.

Further, as the first reaction gas, it may be possible to use an O- and H-containing gas such as a water vapor (H₂O), a H₂ gas + O₂ gas, a H₂O gas + O₂ gas, a H₂O gas + N₂O gas, or a H₂O gas + NO gas. In this case, as the H-containing gas, a deuterium (2H₂) gas may be used instead of the H₂ gas. One or more of these gases can be used as the first reaction gas.

Further, the first reaction gas is not limited to those exemplified, and may be appropriately selected from the O-containing gases that have lower reactivity with the metal-containing material constituting the inner surface of the gas supply pipe 232d than the second processing gas. Further, as the first reaction gas having lower reactivity than the second processing gas, it may be possible to select a gas of the same type as the second processing gas (i.e., a gas having the same molecular structure as the second processing gas), which has a lower concentration than the second processing gas (e.g., the second processing gas diluted with a dilution gas).

Further, in this specification, the joint writing of two gases such as "H₂ gas + O₂ gas" means a mixed gas of a H₂ gas and an O₂ gas. When supplying a mixed gas, two gases may be mixed (premixed) in the supply pipe and then supplied into the process chamber 201, or two gases may be separately supplied to the process chamber from different supply pipes and then mixed (post-mixed) within the process chamber 201. When two gases are separately supplied into the process chamber 201 from different supply pipes, it is preferable that an O-containing gas is supplied into the process chamber 201 through the gas supply pipe 232d (first pipe), and the other gas (which may also be an O-containing gas) is supplied to the process chamber 201 through another gas supply pipe.

After the SiO layer is formed, the valve 243d is closed to stop the supply of the first reaction gas into the process chamber 201. Then, the inside of the process chamber 201 is evacuated to remove gaseous substances and the like remaining in the process chamber 201 from the inside of the process chamber 201. Then, the gas remaining in the process chamber 201 is removed from the process chamber 201 using the same processing procedure as in the purging in step a1 (purging).

### [Step a3]

After step a2 is completed, the second reaction gas is supplied to the wafer 200 in the process chamber 201, i.e., to the SiO layer formed on the wafer 200.

Specifically, the valve 243b is opened to allow the second reaction gas to flow into the gas supply pipe 232b (first pipe). The flow rate of the second reaction gas is adjusted by the MFC 241b. The second reaction gas is supplied into the process chamber 201 through the nozzle 249b and is exhausted from the exhaust port 231a. At this time, the second reaction gas is supplied to the wafer 200 (second reaction gas supply). At this time, the valves 243e to 243g may be opened to supply the inert gas into the process chamber 201 through the nozzles 249a to 249c, respectively.

Processing conditions when supplying the second reaction gas in this step are exemplified as follows.
Second reaction gas supply flow rate: 0.1 to 20 slm, preferably 1 to 10 slm
Second reaction gas supply time: 1 to 120 seconds, preferably 3 to 15 seconds
Other processing conditions may be the same as those in step a1.

By supplying, for example, a nitrogen (N)- and H-containing gas to the wafer 200 as the second reaction gas under the above conditions, at least a portion of the SiO layer formed on the wafer 200 is nitrided (modified). As a result, a silicon oxynitride layer (SiON layer) is formed as a layer containing Si, O, and N on the outermost surface of the wafer 200 as a base.

As the second reaction gas, for example, a nitriding gas may be used. As the nitriding gas, for example, the above-mentioned N- and H-containing gas may be used. The N- and H-containing gas is both an N-containing gas and an H-containing gas.

As the second reaction gas, for example, a hydrogen nitride gas such as an ammonia (NH₃) gas, a diazene (N₂H₂) gas, a hydrazine (N₂H₄) gas, or a N₃H₈ gas may be used. One or more of these gases may be used as the second reaction gas.

After the SiON layer is formed, the valve 243b is closed to stop the supply of the second reaction gas into the process chamber 201. Then, the inside of the process chamber 201 is evacuated to remove gaseous substances and the like remaining in the process chamber 201 from the inside of the process chamber 201. Then, the gas remaining in the process chamber 201 is removed from the process chamber 201 using the same processing procedure as in the purging in step a1 (purging).

### [Performing a Predetermined Number of Times]

The cycle of performing steps a1 to a3 in the named order non-simultaneously, i.e., without synchronization, is performed n times (where n is an integer of 1 or 2 or more), whereby for example, a SiON film having a predetermined thickness can be formed as a film having a predetermined thickness on the surface of the wafer 200 as a base. Preferably, the above-described cycle is repeated multiple times. That is, it is preferable that the thickness of the SiON layer formed per cycle is set to be smaller than a desired film thickness and the above-mentioned cycle is repeated multiple times until the thickness of the SiON film formed by stacking the SiON layers reaches the desired film thickness.

As described above, in step A, the inert gas as an intrusion suppressing gas is supplied into the process chamber 201 from the nozzle 249c. However, only by supplying the intrusion suppressing gas, it may not be possible to suppress by-products generated within the process chamber 201 from intruding into the nozzle 249c and the gas supply pipe 232c. Furthermore, in step A, if the second pipe temperature is lower than the first temperature, for example, lower than 160 degrees C, when the by-products generated in the process chamber 201 intrude (backflow) into the second pipe from the inside of the process chamber 201, it may be difficult to suppress the intruding by-products from adhering to (depositing on) the inside of the second pipe. To solve this problem, by increasing the second pipe temperature to a temperature equal to or higher than the first temperature, it is possible to suppress the by-products intruding from the inside of the process chamber 201 into the second pipe from adhering to the inside of the second pipe. By setting the second pipe temperature to a temperature higher than the first temperature, for example, a temperature 20 degrees C or more higher than the first temperature, it is possible to more effectively suppress the by-products intruding from the inside of the process chamber 201 into the second pipe from adhering to the inside of the second pipe. The temperature higher than the first temperature can be said to be a temperature at which the by-products can be suppressed from adhering to the inside of the second pipe. However, if the second pipe temperature is excessively high, for example, 250 degrees C or higher, the pipe accessory members made of resin or the like, such as a sealing member may burn out. Therefore, it is preferable that the second pipe temperature is, for example, 250 degrees C or lower. The by-products adhering to the inside of the second pipe include not only the by-products intruding from the process chamber 201 but also the by-products generated when the first processing gas intruding into the second pipe is thermally decomposed in the second pipe.

### (Second Pipe Temperature Lowering Process: Step C)

After the end of step A and before the start of step B, which will be described later, a set temperature of the second pipe, i.e., the control temperature of the pipe heater 233c is changed from the first temperature to a third temperature. At this time, the power supply to the pipe heater 233c is feedback-controlled based on the temperature information detected by the pipe temperature sensor 234c so that the second pipe temperature has a desired temperature distribution. The third temperature is a temperature lower than the second temperature, which is lower than the first temperature. The process is kept on standby until the second pipe temperature drops to the second temperature.

### (Second Process: Step B)

When the second pipe temperature drops from the first temperature to the second temperature, step B is started at that timing. In this step, the second processing gas containing O is supplied to the wafer 200 in the process chamber 201, i.e., to the SiON film formed on the wafer 200. Hereinafter, the second processing gas containing O may be simply referred to as a second processing gas.

Specifically, the valve 243c is opened to allow the second processing gas to flow into the gas supply pipe 232c (second pipe). The flow rate of the second processing gas is adjusted by the MFC 241c. The second processing gas is supplied into the process chamber 201 through the nozzle 249c and is exhausted from the exhaust port 231a. At this time, the second processing gas is supplied to the wafer 200 (second processing gas supply). At this time, the valves 243e to 243g may be opened to supply an inert gas into the process chamber 201 through the nozzles 249a to 249c, respectively.

Herein, by supplying the second processing gas, which is an O-containing gas, into the gas supply pipe 232c (second pipe) whose inner surface is made of a metal-containing material, an oxidation reaction may occur between the metal-containing materials such as SUS, which constitutes the inner surface and the second processing gas. The heat generated due to the oxidation reaction may increase the second pipe temperature and may burn out pipe accessory members made of resin or the like, such as a sealing member and may generate contaminants due to the burnout.

More specifically, nickel (Ni) contained in, for example, stainless steel acts as a catalyst on the second processing gas containing O and may decompose the second processing gas to generate O atoms (atomic oxygen). Since the O atoms generated in this way are highly reactive, the O atoms tend to cause an oxidation reaction with the metal-containing material and the associated heat generation. As the second pipe temperature increases due to this heat generation, the above-mentioned catalytic reaction and the generation of O atoms are further accelerated, making it difficult to suppress an increase in the second pipe temperature.

In this step, as will be described later, by supplying the second processing gas while keeping the second pipe temperature below the second temperature, it is possible to maintain a state in which an oxidation reaction does not substantially occur, thereby suppressing an increase in the second pipe temperature.

The processing conditions when supplying the second processing gas in this step are exemplified as follows.
Second pipe temperature: the second temperature or lower, for example, 0 to 155 degrees C, preferably room temperature (25 degrees C) to 150 degrees C, more preferably 100 to 120 degrees C
Second processing gas supply concentration: 100 to 300 g/m³, preferably 200 to 300 g/m3
Second processing gas supply time: 30 to 180 minutes, preferably 45 to 120 minutes. Other processing conditions may be the same as those in step a1.

By supplying the second processing gas to the wafer 200 under the above conditions, it is possible to subject the SiON film formed on the wafer 200 to treatments, for example, removal of impurities contained in the SiON film, repair of defects, and densification and hardening of the SiON film.

Further, if the first pipe temperature becomes lower than the first temperature, for example, lower than 160 degrees C, it may be difficult to suppress the by-products of the first processing gas supplied in step A and remaining in the first pipe from adhering to (depositing on) the inside of the first pipe. By increasing the first pipe temperature to a temperature equal to or higher than the first temperature in step B, it is possible to suppress the by-products of the first processing gas remaining in the first pipe from adhering to the inside of the first pipe. Further, by setting the first pipe temperature to a temperature higher than the first temperature, for example, a temperature higher than the first temperature by 20 degrees C or more in step B, it is possible to more effectively suppress the by-products of the first processing gas remaining in the first pipe from adhering to the inside of the first pipe. The temperature higher than the first temperature can be said to be a temperature at which the by-products of the first processing gas can be suppressed from adhering to the inside of the first pipe. However, if the first pipe temperature is excessively high, for example, 250 degrees C or higher, pipe accessory members made of resin or the like, such as a sealing member may burn out. Therefore, it is preferable that the first pipe temperature is set to, for example, 250 degrees C or lower.

Further, if the first pipe temperature is lower than the first temperature, for example, lower than 160 degrees C, when the by-products of the second processing gas generated in the process chamber 201 intrude (backflow) into the first pipe from the inside of the process chamber 201 in step B, it may be difficult to suppress the by-products from adhering to the inside of the first pipe. By increasing the first pipe temperature to a temperature equal to or higher than the first temperature in step B, it is possible to suppress the by-products of the second processing gas that have intruded into the first pipe from adhering to the inside of the first pipe. Further, by setting the first pipe temperature to a temperature higher than the first temperature, for example, a temperature higher than the first temperature by 20 degrees C or more in step B, it is possible to more effectively suppress the by-products of the second processing gas intruding into the first pipe from adhering to the inside of the first pipe. The temperature higher than the first temperature can be said to be a temperature at which the by-products of the second processing gas can be suppressed from adhering to the inside of the first pipe.

Furthermore, if the second pipe temperature exceeds the second temperature, for example, 155 degrees C, it may be difficult to avoid an oxidation reaction between the metal-containing material constituting the inner surface of the second pipe and the second processing gas. As a result, it is difficult to suppress the second pipe temperature from increasing, making it difficult to avoid the burnout of pipe accessory members made of resin or the like, such as a sealing member and the generation of contaminants. By setting the second pipe temperature to the second temperature or lower, it is possible to suppress an oxidation reaction between the metal-containing material constituting the inner surface of the second pipe and the second processing gas. By setting the second pipe temperature to a temperature lower than the second temperature, for example, 150 degrees C or lower, it is possible to effectively suppress an oxidation reaction between the metal-containing material constituting the inner surface of the second pipe and the second processing gas. By setting the second pipe temperature to a temperature lower than the second temperature, for example, 120 degrees C or lower, it is possible to more effectively suppress an oxidation reaction between the metal-containing material constituting the inner surface of the second pipe and the second processing gas. The second temperature can be said be a temperature at which no substantial reaction occurs between the metal-containing material and the second processing gas. The first temperature can be said to be a temperature at which a substantial reaction between the metal-containing material and the second processing gas occurs.

However, if the second pipe temperature is excessively low, for example, below 0 degrees C, when even a small amount of by-products generated by the supply of the second processing gas into the process chamber 201 intrudes (backflows) into the second pipe, it may be difficult to prevent the by-products from adhering to the inside of the second pipe. By setting the second pipe temperature to, for example, 0 degrees C or higher, it is possible to reduce the amount of by-products adhering to the inside of the second pipe when the by-products generated in the process chamber 201 have intruded into the second pipe. Furthermore, by setting the second pipe temperature to 25 degrees C or higher, it is possible to significantly reduce the amount of by-products adhering to the inside of the second pipe when the by-products generated in the process chamber 201 have intruded into the second pipe. In addition, by setting the second pipe temperature to 100 degrees C or higher, it is possible to more reliably reduce the amount of by-products adhering to the inside of the second pipe when the by-products generated in the process chamber 201 have intruded into the second pipe.

The second processing gas supply time may be set to be longer than the supply time of the first O-containing gas for each cycle illustrated in step a2. Further, the second processing gas supply time may be set to be longer than the supply time of the first processing gas for each cycle in step A (the total supply time of the precursor gas, the first reaction gas, and the second reaction gas).

As the second processing gas, for example, a plasma-excited O-containing gas obtained by plasma-exciting an O-containing gas using a plasma excitation part (not shown) or the like may be used. The plasma-excited O-containing gas may contain, for example, atomic oxygen (O), or hydroxyl radicals (OH radicals). As the plasma-excited O-containing gas, the first O-containing gas exemplified in step a2 may be used.

Further, as the second processing gas, a gas containing at least one of a hydrogen peroxide (H₂O₂) gas and an ozone (O₃) gas may be used.

The second processing gas is not limited to those exemplified, but may be appropriately selected from the O-containing gases that causes a substantial exothermic reaction with the metal-containing material constituting the inner surface of the gas supply pipe 232c (second pipe).

Further, as the second processing gas, an O-containing gas having a higher activity than the first O-containing gas may be used. More specifically, the second reaction gas may be appropriately selected from the O-containing gases that have higher reactivity with the metal-containing material constituting the inner surface of the gas supply pipe 232c than the first processing gas. One or more of these gases may be used as the second processing gas.

When the second pipe temperature reaches a fourth temperature (upper limit temperature or critical temperature) higher than the second temperature during the execution time of this step, the supply of the second processing gas or the like is stopped and the execution of this step is stopped. Then, when the second pipe temperature drops to the second temperature, the execution of this step is restarted.

When the execution time of this step reaches a predetermined time, the execution of this step is terminated.

### (After-Purging and Atmospheric Pressure Restoration)

After step B is completed, the inert gas as a purge gas is supplied into the process chamber 201 from each of the nozzles 249a to 249c and is exhausted from the exhaust port 231a. As a result, the inside of the process chamber 201 is purged, and the gases, reaction by-products, and the like remaining in the process chamber 201 are removed from the inside of the process chamber 201 (after-purging). Thereafter, the atmosphere inside the process chamber 201 is replaced with an inert gas (inert gas replacement) and the pressure inside the process chamber 201 is returned to the atmospheric pressure (atmospheric pressure restoration).

### (Boat Unloading and Wafer Discharging)

Thereafter, the seal cap 219 is lowered by the boat elevator 115, and the lower end of the manifold 209 is opened. Then, the processed wafers 200 are unloaded from the lower end of the manifold 209 to the outside of the reaction tube 203 while being supported by the boat 217 (boat unloading). After the boat is unloaded, the shutter 219s is moved and the lower end opening of the manifold 209 is sealed by the shutter 219s via the O-ring 220c (shutter closing). The processed wafers 200 are discharged from the boat 217 after they are unloaded to the outside of the reaction tube 203 (wafer discharging).

### (3) Effects of the Present Embodiment

According to the present embodiment, one or more of the following effects may be obtained.

(a) In step B, when supplying the second processing gas through the second pipe, the second pipe temperature is lowered to the second temperature lower than the first temperature, thereby suppressing an increase in the temperature of the second pipe. Specifically, in step B, when supplying the second processing gas through the second pipe, the second pipe temperature is lowered to a temperature at which an oxidation reaction between the metal-containing material constituting the inner surface of the second pipe and the second processing gas does not occur. This makes it possible to suppress an increase in the temperature of the second pipe. By suppressing an increase in the temperature of the second pipe, it is possible to prevent burnout of pipe accessory members made of resin, such as sealing member and it is also possible to prevent generation of contaminants due to an oxidation reaction between the metal-containing material and the second processing gas.

In step B, by continuously maintaining the second pipe temperature at the second temperature or lower while performing the second process, it is possible to reliably prevent the burning of the sealing member and the like and the generation of contaminants.

Further, in step A, when supplying the first processing gas through the first pipe, the second pipe is heated to a temperature equal to or higher than the first temperature. Therefore, even if the by-products generated by the supply of the first processing gas into the process chamber 201 intrude into the second pipe from the inside of the process chamber 201, it is possible to suppress the by-products from adhering to the second pipe. Specifically, in step A, when supplying the first processing gas, the second pipe temperature is set to equal to or higher than the first temperature at which the by-products of the first processing gas do not adhere to the inside of the second pipe. This makes it possible to suppress the by-products from adhering to the inside of the second pipe.

Further, in step A, by continuously maintaining the second pipe temperature at the first temperature or higher while performing the first process, it is possible to reliably suppress the by-products of the first processing gas from adhering to the inside of the second pipe.

Further, (b) the increase in the pipe temperature is a problem that becomes more prominent when using a gas which is highly reactive (highly active) with the metal-containing material constituting the inner surface of the pipe. According to the present embodiment, in step B, an O-containing gas having a higher activity than the first O-containing gas is used as the second processing gas. Therefore, it is possible to reliably obtain an effect of suppressing a rise of the pipe temperature according to the present disclosure.

(c) From step A to step B, the first process and the second process are performed in the same process chamber without unloading the substrate from the process chamber 201. This makes it possible to prevent contamination of the substrate and adhesion of particles that may occur when the substrate is loaded or unloaded. Furthermore, the productivity (throughput) can be improved in some cases by reducing the loading and unloading of the substrate.

(d) In step A, by not supplying the second processing gas into the process chamber 201 through the second pipe, it is possible to suppress an increase in the temperature of the second pipe. Specifically, in step A in which the second pipe temperature is equal to or higher than the first temperature at which an oxidation reaction occurs between the metal-containing material constituting the inner surface of the second pipe and the second processing gas, the oxidation reaction is prevented from occurring by not supplying the second processing gas. This makes it possible to reliably suppress an increase in the temperature of the second pipe. By suppressing the increase in the temperature of the second pipe, it is possible to prevent the burnout of pipe accessory members made of resin, such as a sealing member and it is also possible to prevent the generation of contaminants due to an oxidation reaction between the metal-containing material and the second processing gas.

(e) In step B, by not supplying the first processing gas into the process chamber 201, it is possible to suppress the by-products of the first processing gas from adhering to the inside of the second pipe. Specifically, in step B in which the second pipe temperature is maintained at a temperature equal to or lower than the second temperature at which it is difficult to suppress the adhesion of the by-products of the first processing gas, the first processing gas is not supplied to prevent generation of the by-products. Thus, it is possible to reliably prevent the by-products of the first processing gas from adhering to the inside of the second pipe.

(f) In step B, by not supplying gases other than the second processing gas and the inert gas into the process chamber 201, it is possible to suppress the by-products of other gases from adhering to the inside of the second pipe. Specifically, in step B in which the second pipe temperature is maintained at a temperature equal to or lower than the second temperature at which it is difficult to suppress the adhesion of the by-products of other gases, the other gases are not supplied to prevent generation of the by-products. Thus, it is possible to reliably prevent the by-products of the other gases from adhering to the inside of the second pipe.

(g) In step B, by maintaining the temperature of the first pipe heated to the first temperature or higher in step A at the first temperature or higher, it is possible to suppress the by-products of the first processing gas supplied in step A and remaining in the first pipe from adhering to the inside of the first pipe. Specifically, in step B, by maintaining the first pipe temperature at a temperature equal to or higher than the first temperature at which the by-products of the first processing gas do not adhere to the inside of the first pipe, it is possible to suppress the by-products of the first processing gas supplied in step A and remaining in the first pipe from adhering to the inside of the first pipe.

Furthermore, in step B, the temperature of the first pipe heated to the first temperature or higher in step A is maintained at the first temperature or higher. Therefore, even if the by-products of the second processing gas supplied in step B intrude into the first pipe, it is possible to prevent the byproducts from adhering to the inside of the first pipe. Specifically, in step B, by setting the first pipe temperature to a temperature equal to or higher than the first temperature at which the by-products of the second processing gas do not adhere to the inside of the first pipe, it is possible to suppress the by-products of the second processing gas from adhering to the inside of the first pipe.

In step B, the above effects can be reliably obtained by continuously maintaining the first pipe temperature at a temperature equal to or higher than the first temperature while the second process is being performed.

(h) In step B, if the second pipe temperature reaches a fourth temperature (upper limit temperature or critical temperature) higher than the second temperature while the second process is being executed, the second process is stopped. This makes it possible to prevent the second pipe temperature from exceeding the upper limit temperature (fourth temperature).

(i) During the period between step A and step B, step C is performed in which the second pipe temperature is lowered to the second temperature while not performing the first process and the second process. By performing the second process, it is possible to suppress the second pipe temperature from increasing.

(j) In step C, by starting step B at the timing when the second pipe temperature has dropped to the second temperature, it is possible to shorten the time for lowering the second pipe temperature and to improve the throughput.

(k) In step C, the second pipe temperature is set to a third temperature lower than the second temperature. Therefore, in step B, for example, if heat generation occurs in the second pipe due to an unintended oxidation reaction, it is possible to maintain the second pipe temperature at a temperature equal to or lower than the second temperature and to prevent a rapid temperature rise.

(l) In steps A and B, by not supplying the nitrogen-containing gas into the process chamber 201 through the second pipe, the second processing gas containing O and the nitrogen-containing gas are mixed in the second pipe. Therefore, it is possible to prevent the generation of particles, nitric acid (HNO₃), and the like that may corrode pipes and the like.

### <Other Embodiments of the Present Disclosure>

The embodiment of the present disclosure has been specifically described above. However, the present disclosure is not limited to the above-described embodiment, and various changes may be made without departing from the gist thereof.

For example, in the above-described embodiment, there has been described the case where after stopping the supply of the first processing gas (after completing the execution of step A), in step C, the temperature of the second pipe is lowered from the first temperature to the second temperature. However, the present disclosure is not limited to such an embodiment. For example, a process of lowering the temperature of the second pipe from the first temperature to the second temperature may be started while continuing to supply the first processing gas (i.e., while performing step A). In this case, the same effects as in the above-described embodiment may be obtained. Furthermore, since the temperature of the second pipe starts to decrease during the execution of step A, it is possible to shorten the cycle time and to further improve the throughput.

For example, a fluoride layer of a metal-containing material may be formed by subjecting the inner surface of the second pipe to a fluorinating process. By forming the fluoride layer in advance on the inner surface of the second pipe made of a metal-containing material, it is possible to reliably suppress the occurrence of an oxidation reaction between the second processing gas and the metal-containing material, and to further enhance the effect of suppressing the increase in the temperature of the second pipe. For example, a layer of fluorinated metal-containing material (i.e., fluoride layer) can be formed on the inner surface of the second pipe by performing a process of exposing the inner surface of the second pipe to a fluorine (F)-containing gas such as a F₂ gas in advance. Moreover, a known fluorination processing technique may also be used as a method of forming a fluoride layer on the inner surface of the second pipe.

Further, the fluoride layer may be formed not only on the second pipe but also on the inner surface of the first pipe. Furthermore, the fluoride layer may not be formed on the inner surface of the first pipe, but may be formed only on the inner surface of the second pipe.

For example, an oxide film such as a silicon oxide film (SiO film) may be formed by performing a film formation process on the inner surface of the second pipe. By forming an oxide film in advance to cover the inner surface of the second pipe made of a metal-containing material, it is possible to more reliably suppress the occurrence of an oxidation reaction between the second processing gas and the metal-containing material, and to further enhance the effect of the temperature rise suppressing effect for the second pipe in the above-described embodiment. For example, by performing a cycle including a step of supplying a precursor gas containing silicon (Si) and a step of supplying an O-containing gas as an oxidizing agent on the inner surface of the second pipe a predetermined number of times, it is possible to form (deposit) a Si-containing oxide film on the inner surface of the second pipe. In addition, a known film formation technique may also be used as a method of forming an oxide film on the inner surface of the second pipe.

Further, the oxide film may be formed not only on the second pipe but also on the inner surface of the first pipe. Furthermore, the oxide film may not be formed on the inner surface of the first pipe, but may be formed only on the inner surface of the second pipe.

For example, in step C, after changing the control temperature of the pipe heater 233c from the first temperature to the third temperature, the power supply to the pipe heater 233c may be stopped until at least the second pipe temperature drops from the first temperature to the third temperature. Further, in step C, instead of changing the control temperature of the pipe heater 233c from the first temperature to the third temperature, the power supply to the pipe heater 233c may simply be stopped. Further, a cooling device (not shown) may be used when lowering the temperature of the second pipe. In these cases, as well, the same effects as those of the above-described embodiment can be obtained. Furthermore, when the cooling device is used, the time required to lower the temperature of the second pipe can be shortened and the throughput can be improved. The cooling device may be configured by, for example, an air cooling device, a water cooling device, or a Peltier type cooling device.

For example, in the above-described embodiment, there has been described the example in which stainless steel is used as the metal-containing material constituting the inner surfaces of the first pipe and the second pipe. However, the present disclosure is not limited to such an embodiment. For example, the metal-containing material constituting the inner surfaces of the first pipe and the second pipe may be iron (Fe), copper (Cu), aluminum (Al), nickel (Ni), or the like and may be Hastelloy (registered trademark) obtained by adding Fe, molybdenum (Mo), chromium (Cr), and the like to nickel (Ni), or Inconel (registered trademark) obtained by adding Fe, Cr, niobium (Nb), Mo, and the like to Ni. In these cases, the same effects as those of the above-described embodiment can be obtained.

For example, in the above-described embodiment, there has been described the case where the predetermined element contained in the precursor gas is Si. However, the present disclosure is not limited to such an embodiment. For example, the predetermined element may be a metal element such as titanium (Ti), zirconium (Zr), hafnium (Hf), tantalum (Ta), Nb, Al, Mo, tungsten (W), germanium (Ge), or the like. In these cases, a metal-based oxide film such as a titanium oxynitride film (TiON film), a zirconium oxynitride film (ZrON film), a hafnium oxynitride film (HfON film), a tantalum oxynitride film (TaON film), a niobium oxynitride film (NbON film), an aluminum oxynitride film (AlON film), a molybdenum oxynitride film (MoON film), a tungsten oxynitride film (WON film), or a germanium oxynitride film (GeON film) is formed. In these cases, the same effects as those of the above-described embodiment can be obtained.

It is preferable that the recipe used for each process is prepared separately according to the processing contents and are recorded and stored in the memory device 121c via an electric communication line or an external memory device 123. When starting each process, it is preferable that the CPU 121a properly selects an appropriate recipe from a plurality of recipes recorded and stored in the memory device 121c according to the process contents. This makes it possible to form films of various film types, composition ratios, film qualities, and film thicknesses with high reproducibility in one substrate processing apparatus. In addition, the burden on an operator can be reduced and each process can be quickly started while avoiding operation errors.

The above-described recipes are not limited to the newly prepared ones, but may be prepared by, for example, changing the existing recipes already installed in the substrate processing apparatus. In the case of changing the recipes, the recipes after the change may be installed in the substrate processing apparatus via an electric communication line or a recording medium in which the recipes are recorded. In addition, the input/output device 122 provided in the existing substrate processing apparatus may be operated to directly change the existing recipes already installed in the substrate processing apparatus.

In the above-described embodiment, there has been described the example in which a film is formed by using a batch type substrate processing apparatus for processing a plurality of substrates at a time. The present disclosure is not limited to the above-described embodiment, but may be suitably applied to, for example, a case where a film is formed using a single-substrate type substrate processing apparatus for processing one or several substrates at a time. Further, in the above-described embodiment, there has been described the example in which a film is formed using a substrate processing apparatus including a hot wall type process furnace. The present disclosure is not limited to the above-described embodiment, but may also be suitably applied to a case where a film is formed using a substrate processing apparatus including a cold wall type process furnace.

Even when these substrate processing apparatuses are used, each process may be performed under the processing procedures and processing conditions as those of the above-described embodiment and modifications. The same effects as those of the above-described embodiment and modifications may be obtained.

The above-described embodiment and modifications may be used in combination as appropriate. The processing procedure and processing conditions at this time may be, for example, the same as the processing procedures and processing conditions of the above-described embodiment and modifications.

According to the present disclosure in some embodiments, it is possible to, when supplying an oxygen-containing gas through a pipe whose inner surface is made of a metal-containing material, suppress an increase in pipe temperature due to the reaction between the inner surface and the gas.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the disclosures. The accompanying claims and their equivalents are intended to cover such forms or modifications as would fall within the scope of the disclosures.

## Claims

1. A method of processing a substrate, comprising:
(a) performing a first process to the substrate accommodated in a process container by supplying a first processing gas into the process container through a first pipe different from a second pipe, which is connected to the process container and includes an inner surface made of a metal-containing material, in a state in which the second pipe is heated to a first temperature or higher; and
(b) performing a second process to the substrate by supplying a second processing gas containing oxygen into the process container through the second pipe in a state in which a temperature of the second pipe is lowered to a second temperature lower than the first temperature.

2. The method of Claim 1, wherein in (a), a supply of the second processing gas into the process container through the second pipe is not performed.

3. The method of Claim 1 or 2, wherein in (b), a supply of the first processing gas into the process container is not performed.

4. The method of any one of Claims 1 to 3, wherein in (b), a supply of a gas other than the second processing gas and an inert gas into the process container is not performed.

5. The method of any one of Claims 1 to 4, wherein an inner surface of the first pipe is made of the metal-containing material,
wherein the first processing gas includes a first oxygen-containing gas, and
wherein a reactivity of the first oxygen-containing gas with the metal-containing material is smaller than a reactivity of the second processing gas with the metal-containing material.

6. The method of any one of Claims 1 to 5, wherein the second processing gas is a gas containing at least one selected from the group of a hydrogen peroxide gas, an ozone gas, and a plasma-excited oxygen-containing gas.

7. The method of any one of Claims 1 to 6, wherein in (b), a state in which a temperature of the first pipe is heated to the first temperature or higher is maintained.

8. The method of any one of Claims 1 to 7, wherein in (b), if the temperature of the second pipe reaches a fourth temperature higher than the second temperature while performing the second process, performing the second process is stopped.

9. The method of any one of Claims 1 to 8, further comprising:
(c) in a period between (a) and (b), lowering the temperature of the second pipe to the second temperature in a state in which the first process and the second process are not performed.

10. The method of Claim 9, wherein after (a), (b) is started at a timing at which the temperature of the second pipe drops to the second temperature.

11. The method of Claim 9 or 10, wherein in (c), a third temperature lower than the second temperature is set to a control temperature of a heater installed to heat the second pipe.

12. The method of any one of Claims 1 to 11, wherein in (a) and (b), a supply of a nitrogen-containing gas into the process container through the second pipe is not performed.

13. A method of manufacturing a semiconductor device, comprising:
(a) performing a first process to a substrate accommodated in a process container by supplying a first processing gas into the process container through a first pipe different from a second pipe, which is connected to the process container and includes an inner surface made of a metal-containing material, in a state in which the second pipe is heated to a first temperature or higher; and
(b) performing a second process to the substrate by supplying a second processing gas containing oxygen into the process container through the second pipe in a state in which a temperature of the second pipe is lowered to a second temperature lower than the first temperature.

14. A program that causes, by a computer, a substrate processing apparatus to perform a process comprising:
(a) performing a first process to a substrate accommodated in a process container by supplying a first processing gas into the process container through a first pipe different from a second pipe, which is connected to the process container and includes an inner surface made of a metal-containing material, in a state in which the second pipe is heated to a first temperature or higher; and
(b) performing a second process to the substrate by supplying a second processing gas containing oxygen into the process container through the second pipe in a state in which a temperature of the second pipe is lowered to a second temperature lower than the first temperature.

15. A substrate processing apparatus, comprising:
a process container configured to process a substrate;
a first processing gas supply system configured to supply a first processing gas into the process container through a first pipe connected to the process container;
a second processing gas supply system configured to supply a second processing gas containing oxygen into the process container through a second pipe different from the first pipe, the second pipe including an inner surface made of a metal-containing material and connected to the process container;
a heater configured to heat the second pipe; and
a controller configured to be capable of controlling the first processing gas supply system, the second processing gas supply system, and the heater to perform a process including:
(a) performing a first process to the substrate by supplying the first processing gas into the process container through the first pipe in a state in which the second pipe is heated to a first temperature or higher; and
(b) performing a second process to the substrate by supplying the second processing gas into the process container through the second pipe in a state in which a temperature of the second pipe is lowered to a second temperature lower than the first temperature.
